# EUROPEAN PATENT SPECIFICATION

(11) **EP 4 246 229 B1**
(45) Date of publication and mention of the grant of the patent: **09.04.2025**
(21) Application number: 22191676.0
(22) Date of filing: 23.08.2022
(51) Int. Cl.: G03F 7/00, B29D 11/00, G02B 3/00, H01L 27/146

(54) **PHOTOMASK, METHOD FOR MANUFACTURING LENS, AND METHOD FOR MANUFACTURING PHOTODETECTOR**
PHOTOMASKE, VERFAHREN ZUR HERSTELLUNG EINER LINSE UND VERFAHREN ZUR HERSTELLUNG EINES PHOTODETEKTORS
PHOTOMASQUE, PROCÉDÉ DE FABRICATION DE LENTILLE ET PROCÉDÉ DE FABRICATION DE PHOTODÉTECTEUR

(30) Priority: 17.03.2022 JP 2022042709; 15.07.2022 JP 2022113908
(43) Date of publication of application: 20.09.2023
(73) Proprietor: KABUSHIKI KAISHA TOSHIBA, Minato-ku Tokyo 105-0023 (JP)
(72) Inventor: KWON, Honam, Tokyo, 105-0023 (JP); SHIMIZU, Mariko, Tokyo, 105-0023 (JP); OKAMOTO, Kazuaki, Tokyo, 105-0023 (JP); SUZUKI, Kazuhiro, Tokyo, 105-0023 (JP)
(74) Representative: Hoffmann Eitle

(56) References cited:
- JP-A- 2007 298 625
- JP-A- 2009 222 850
- JP-B2- 5 629 964
- US-A1- 2007 122 718

## Description

### FIELD

Embodiments described herein relate generally to a photomask, a method for manufacturing a lens, and a method for manufacturing a photodetector.

### BACKGROUND

A photodetector that detects light incident on a semiconductor region includes a lens. In order to improve the detection efficiency by the photodetector, it is desirable that the focusing rate of the lens is higher.

JP 5 629964 B2 discloses features falling under the preamble of claim 1. JP 2007-298625 A, JP 2009-222850 A, and US 2007/122718 A1 are further prior art.

The invention is defined by the independent claims.

### BRIEF DESCRIPTION OF THE DRAWINGS

FIG. 1 is a schematic plan view of a photomask according to a first embodiment;
FIG. 2 is a schematic plan view of an enlarged part of FIG. 1;
FIG. 3 is a schematic plan view of a further enlarged part of FIG. 1;
FIG. 4 is a schematic plan view of another example of a further enlarged part of FIG. 1, not falling under claim 1;
FIG. 5 is a schematic plan view of the photomask according to the first embodiment;
FIG. 6 is a schematic plan view of another photomask not falling under claim 1;
FIG. 7 is a schematic plan view of an enlarged part of FIG. 6;
FIG. 8 is a schematic plan view of another photomask not falling under claim 1;
FIG. 9 is a schematic plan view of a method for manufacturing a lens by using the photomask according to the first embodiment;
FIG. 10 is a schematic plan view the lens manufactured by the method for manufacturing the lens of FIG. 9;
FIG. 11 is an image of an electron microscope in a cross section of a lens manufactured by using a photomask according to an example 1;
FIG. 12 is an image of an electron microscope in a cross section of a lens manufactured by using a photomask according to the example 1;
FIG. 13 is a plan view of a photomask according to a comparative example 1;
FIG. 14 is an image of an electron microscope in a cross section of a lens manufactured by using the photomask according to the comparative example 1;
FIG. 15A is an image of an electron microscope of a cut cross section of a lens manufactured by using a photomask according to an example 3, FIG. 15B is an image of the electron microscope of the cut cross section of the lens after processing the lens shown in FIG. 15A;
FIG. 16 is a schematic plan view of another photomask according to the first embodiment;
FIG. 17 is a schematic plan view of an enlarged part of FIG. 16;
FIG. 18 is an image of an electron microscope in a cross section of a lens manufactured by using a photomask according to an example 4;
FIG. 19 is a schematic plan view of a photomask according to a second embodiment not falling under claim 1;
FIG. 20 is a schematic plan view of another photomask according to the second embodiment not falling under claim 1;
FIG. 21 is a schematic plan view of another photomask according to the embodiment not falling under claim 1;
FIG. 22 is a schematic plan view of another photomask according to the embodiment not falling under claim 1; and
FIG. 23 is a schematic plan view of another photomask according to the embodiment not falling under claim 1.

### DETAILED DESCRIPTION

According to one embodiment, a photomask includes a plurality of unit regions arranged in a first direction and a second direction crossing the first direction. Each of the plurality of unit regions includes a first region having a first light-shielding rate, and a second region having a second light-shielding rate different from the first light-shielding rate. The second region is provided around the first region. The unit regions include a first unit region and a second unit region having same size each other. A distance between the first unit region and a center of a range in which the unit regions are arranged is different from a distance between the second unit region and the center. A light-shielding rate of the first unit region is different from a light-shielding rate of the second unit region.

Various embodiments are described below with reference to the accompanying drawings. In the following description, components exhibiting the same or similar functions are designated by the same reference numerals throughout the drawings, and duplicate description will be omitted. It should be noted that each figure is a schematic diagram for describing the embodiment and promoting its understanding, and there are differences in its shape, dimensions, ratio, etc. from the actual device, but these are based on the following description and public known arts. The design can be changed as appropriate.

In the following description and drawings, the notations of n⁺, n⁻, p⁺, and p indicate relative levels of the impurity concentrations. In other words, a notation marked with "+" indicates that the impurity concentration is relatively greater than that of a notation not marked with either "+" or "-"; and a notation marked with "-" indicates that the impurity concentration is relatively less than that of a notation without any mark. When both a p-type impurity and an n-type impurity are included in each region, these notations indicate relative levels of the net impurity concentrations after the impurities are compensated.

In embodiments described below, each embodiment may be implemented by inverting the p-type and the n-type of the semiconductor regions.

### [First embodiment]

According to a first embodiment, a photomask is provided. The photomask includes a plurality of unit regions arranged in a first direction and a second direction crossing the first direction. Each of the plurality of unit regions include a first region having a first light-shielding rate, and a second region having a second light-shielding rate different from the first light-shielding rate. The second region is provided around the first region. The plurality of unit regions include a first unit region and a second unit region having same size each other. A distance between the first unit region and a center of a range in which the plurality of unit regions are arranged is different from a distance between the second unit region and the center, and a light-shielding rate of the first unit region is different from a light-shielding rate of the second unit region.

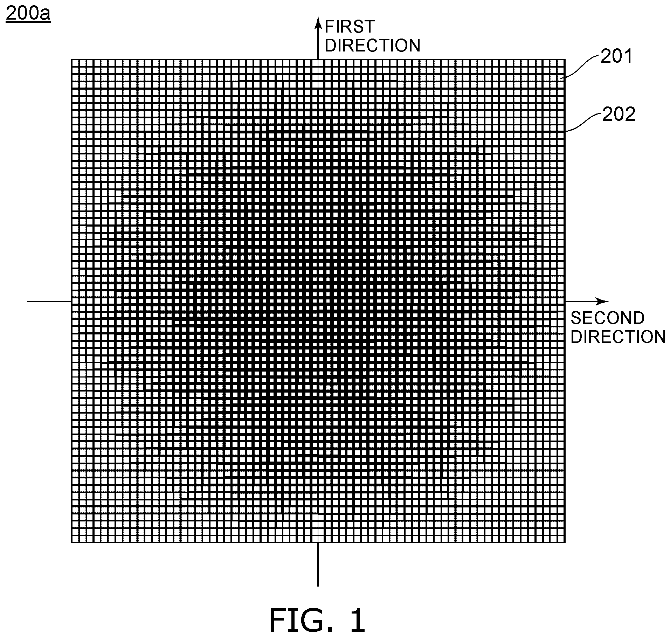

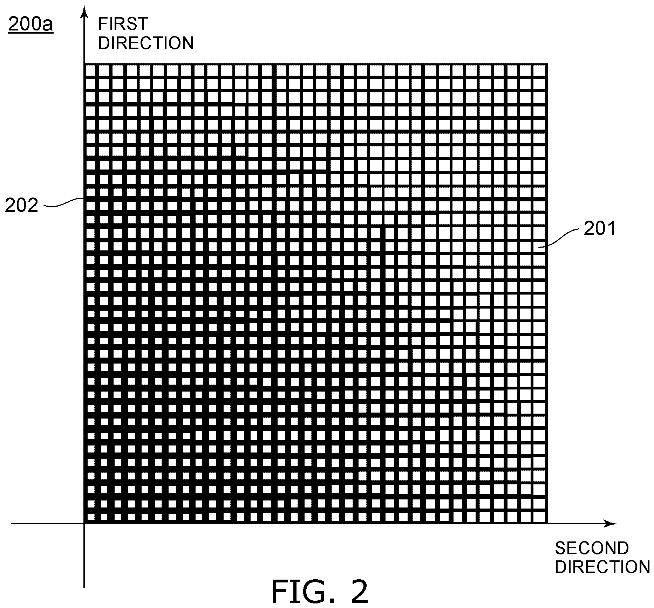

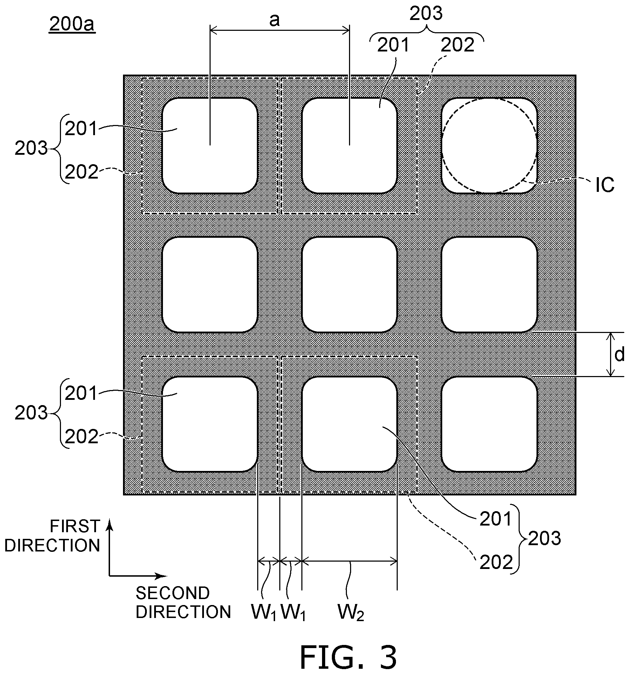

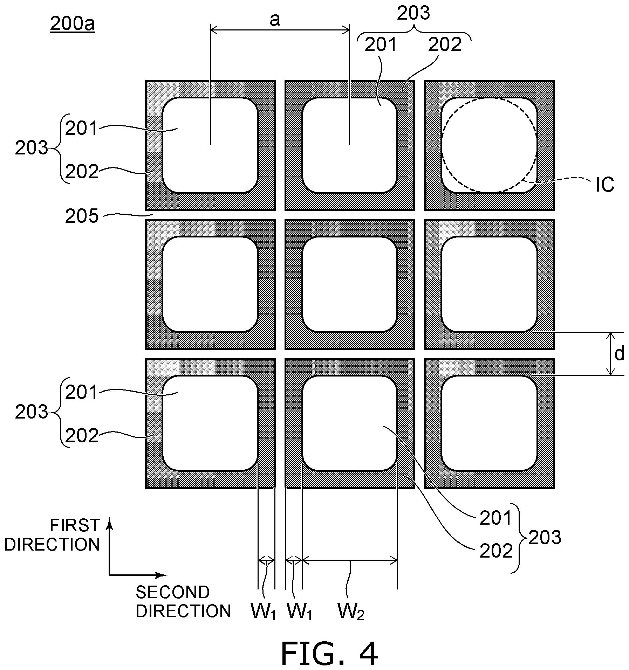

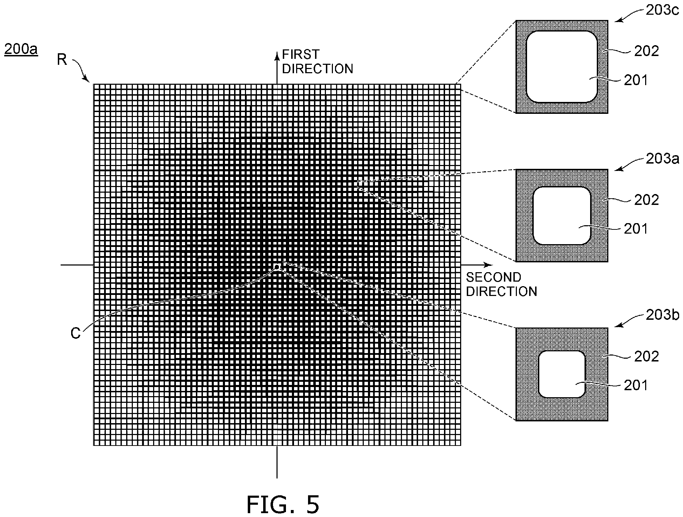

FIGS. 1 and 5 are schematic plan views of a photomask according to a first embodiment. FIG. 2 is a schematic plan view of an enlarged part of FIG. 1. FIG. 3 is a schematic plan view of a further enlarged part of FIG. 1. FIG. 4 is a schematic plan view of other example of a further enlarged part of FIG. 1

An axis that passes through the center of the photomask and is along the first direction and an axis that crosses the first direction and is along the second direction are defined. FIG. 2 is an enlarged view of the first quadrant when the photomask of FIG. 1 is divided into four quadrants by the axis along the first direction and the axis along the second direction. FIG. 3 is a schematic plan view in which a section of FIG. 2 is further enlarged, and shows an example in which the shape of a first region 201 is a substantially quadrangle. FIG. 4 is a schematic plan view of another example of FIG. 3.

In FIGS. 1 to 4, the white portion (without filling) is the first region 201. The black portion (filled) is a second region 202. The first region 201 transmits light more than the second region 202. The second region 202 has a lower light transmittance than the first region 201. The light transmittance of the second region 202 may be zero, and it is not necessary to pass light. For example, the first region 201 is a non-light-shielding portion. The second region 202 is a light-shielding portion. In the example illustrated in FIGS. 1 to 4, a first light-shielding rate of the first region 201 is lower than a second light-shielding rate of the second region 202. The light-shielding rate is the rate at which incident light is blocked in a certain region. The value obtained by subtracting the light-shielding rate from 1 is the transmittance in the region. The shape of the first region 201 may be a regular polygon or a substantially polygon.

A photomask 200a in FIGS. 1 to 4 includes multiple non-light-shielding portions and a light-shielding portion. The multiple non-light-shielding portions are repeatedly arranged two-dimensionally. For example, the multiple non-light-shielding portions are arranged at equal intervals. One light-shielding portion is arranged around each non-light-shielding portion. The multiple non-light-shielding portions and the light-shielding portion are arranged so that the light-shielding rate at the central area of the photomask 200a is higher than the light-shielding rate at the peripheral area. One non-light-shielding portion corresponds to the first region 201. A part of the light-shielding portion corresponds to the second region 202.

The central area of the photomask 200a includes the center of the photomask 200a and is a region having a constant light-shielding rate. For example, in the central area of the photomask 200a, non-light-shielding portions having the same size are provided. The peripheral area is a region of the photomask 200a excluding the central area thereof. The size of the non-light-shielding portion provided in the peripheral area is different from the size of the non-light-shielding portion provided in the central area.

As shown in FIG. 3, the photomask 200a includes multiple unit regions 203. The multiple unit regions 203 are repeatedly arranged in the first direction and the second direction. Each unit region 203 includes the first region 201 and the second region 202 arranged around the first region 201. In accordance with the invention, the second regions 202 adjacent to each other in the first direction or the second direction are in contact with each other.

In FIG. 3, the distance connecting the centers of the adjacent first regions 201 is defined as a first distance a. That is, the first regions 201 are arranged at intervals of the first distance a, and are arranged at intervals of pitch a. When the shape of the first region 201 is a substantially quadrangle as shown in FIG. 3, the center of the first region 201 is considered as follows in order to obtain the distance a. First, the approximate straight lines of the four sides of the first region 201 are obtained, and the four vertices of the quadrangle formed from the four approximate straight lines are determined. Then, diagonal lines of the four vertices are drawn, and the intersection thereof is set as the center of the first region 201. In FIG. 3, W₂ is the length of the first region 201 along the first direction or the second direction. W₁ is the length of the second region 202 along the first or second direction located between the adjacent first regions 201. In FIG. 3, W₂ is the length of the first region 201 in the second direction. W₁ is the length of the second region 202 located between the adjacent first regions 201 in the second direction. The sum of twice W₁ and W₂ is the distance a connecting the centers of the adjacent first regions 201.

In the case where the unit region 203 is square and the lengths of the second regions 202 adjacent to each other on the up, down, left, and right of the unit region 203 are the same, the length of one unit region 203 along the first direction or the second direction is W1 + W2 + W1. Therefore, the length of the unit region 203 is 2W₁ + W₂, which is a distance a.

Assuming that the light-shielding rate of the unit region 203 is a third light-shielding rate, the third light-shielding rate is a ratio of the area of the second region 202 in the unit region 203 to the area of the unit region 203. That is, the third light-shielding rate is the area of the second region in the unit region / the area of the unit region (a²), and is represented by {(2W₁ + W₂)²-W₂²} / (2W₁ + W₂)².

As shown in FIG. 5, the multiple unit regions 203 include a first unit region 203a and a second unit region 203b. The multiple unit regions 203 for forming one lens are arranged in the range R. The center of the range R is defined as the center C. The center C is also, for example, the center of the photomask 200a in the first surface parallel to the first direction and the second direction. The distance between the center C and the first unit region 203a is longer than the distance between the center C and the second unit region 203b. The size of the second unit region 203b is the same as the size of the first unit region 203a. The light-shielding rate of the first unit region 203a is different from the light-shielding rate of the second unit region 203b.

The multiple unit regions 203 may further include a third unit region 203c. The distance between the center C and the first unit region 203a is shorter than the distance between the center C and the third unit region 203c. The size of the third unit region 203c is the same as the size of the first unit region 203a. The light-shielding rates of the first unit region 203a, the second unit region 203b, and the third unit region 203c are different from each other. In the photomask 200a according to the first embodiment, the second unit region 203b is closest to the center C among the multiple unit regions 203. The light-shielding rate of the second unit region 203b is the largest among the multiple unit regions 203. The third unit region 203c is the farthest from the center C among the multiple unit regions 203. The light-shielding rate of the third unit region 203c is the smallest among the light-shielding rates of the multiple unit regions 203.

The third light-shielding rate depends on the length W₁ along the first or second direction of the second region 202 located between the adjacent first regions 201. The length W₂ is influenced by the area of the first region 201. For example, in FIG. 1, there is a gradient in the third light-shielding rates along the first direction or the second direction from the center C of the photomask 200a. In the vicinity of the center of the photomask 200a, the area of the first region 201 is small, so that the length W₁ is large. Light is less likely to pass through than in other regions, and the third light-shielding rate is high. In the peripheral area of the photomask 200a, the length W₂ is small because the area of the first region 201 is large. Light is more easily transmitted than in other regions, and the third light-shielding rate is low.

The sizes of the unit regions 203 are the same as each other. The third light-shielding rate of each unit region 203 is not less than 10% and not more than 90%. In other words, when the first light-shielding rate of the first region 201 is 0 and the second light-shielding rate of the second region 202 is 1, the ratio of the area of the second region 202 in each unit region 203 is not less than 10% and not more than 90%. Each third light-shielding rate is inversely proportional to the square of the distance from the center C. Each third light-shielding rate may be in a relationship obtained by multiplying the ratio inversely proportional to the square of the distance from the center C by the conic constant or the square thereof. The conic constant is set in the range of -0.2 to -5.0. In order to improve the characteristics of the manufactured lens, the conic constant is more preferably in the range of -0.4 to -1.0.

When the third light-shielding rate is smaller than 10%, the length of W₁ is small and the shielding property is insufficient. Therefore, the resolution as a gradation is lost. If W₁ + W₂ is increased to secure the length of W₁ and a new distance of a1 that is constant in the photomask is used, the distance between the opening holes (first region 201) becomes too wide. It is not possible to prepare the gradation of the photomask so that the surface of the lens to be manufactured becomes sufficiently smooth. Further, when the third light-shielding rate is larger than 90%, W₂ in FIG. 3 is smaller than 400 nm, which makes it difficult for light to pass through. If the third light-shielding rate is set to be larger than 90% and W₂ is set to 400 nm or more so that light can pass through, W₁ becomes large and the distance between the opening holes becomes too wide. Therefore, it is not possible to prepare the gradation of the photomask so that the surface of the lens to be manufactured becomes sufficiently smooth.

Preferably, the third light-shielding rate of the unit region 203 of the photomask 200a is not less than 15% and not more than 90%. When the third light-shielding rate is 15% or more, W₁ becomes 50 nm or more. It is possible to prepare the gradation of the photomask 200a so that the surface of the lens to be manufactured becomes sufficiently smooth. Further, when the third light-shielding rate is 90% or less, W₂ can be made larger than 400 nm. Therefore, the phenomenon that although the first region 201 for transmitting light exists, light does not actually transmit can be suppressed. In order to reduce 2W₁ + W₂ and sufficiently smooth the surface of the lens, the third light-shielding rate is more preferably not less than 30% and not more than 80%.

By changing the area of the first region 201 while keeping the distance a, it is possible to make a gradient in the third light-shielding rates of the unit regions 203 from the center C toward the outer periphery of the photomask 200a. For example, the area of the first region 201 is the smallest near the center C of the photomask 200a and increases in proportion to the distance from the center C of the photomask 200a. That is, the area of the opening in FIGS. 1 to 5 increases in proportion to the distance from the center C of the photomask 200a while keeping the distance a between the unit regions 203 constant. As a result, the third light-shielding rate of the unit region 203 becomes smaller as the distance from the center C of the photomask 200a increases, and the third light-shielding rates of the unit regions 203 can have a gradient.

As shown in FIG. 4, and not in accordance with the terms of claim 1, adjacent second regions 202 may be separated from each other. A separation region 205 is provided between the second regions 202 adjacent to each other in the first direction or the second direction. The light-shielding rate of the separation region 205 is different from the light-shielding rate of the second region 202. The light-shielding rate of the separated region 205 per unit area may be the same as the light-shielding rate of the first region 201 per unit area. In this case, the distance between the separation regions 205 is narrow, and inherently no light may pass between the second regions 202. In this case, the length of the unit region 203 is smaller than the distance a connecting the centers of the adjacent first regions 201.

In the first direction or the second direction, it is preferable that the constant distance a is not less than 500 nm and not more than 2500 nm. When the distance a is smaller than 500 nm, it means that, for example, the distance between the centers of the adjacent first regions 201 in FIG. 3 is smaller than 500 nm. For example, when an i-line exposure machine is used, the length W₂ of about 400 nm or more is required for light to pass through the first region 201. When the length W₂ is 400 nm or more, the distance (2W₁) between the adjacent first regions 201 is smaller than 100 nm. In the photomask 200a, if the length smaller than 100 nm is changed by, for example, 5 nm, only a maximum of 19 kinds of lengths can exist. As a result, when a lens is manufactured using this photomask 200a, the surface of the manufactured lens is not smooth. The distance a is preferably 500 nm or more in order to increase the kinds of distances between adjacent first regions 201. Further, when the distance a is larger than 2500 nm, the length W₁ is also sufficiently large, so that a sufficiently different kind of different length 2W₁ can be present in the photomask 200a. However, since the distance between the adjacent first regions 201 is large, the surface of the manufactured lens is not smooth. In order to sufficiently smooth the surface of the manufactured lens, the distance a is preferably 2500 nm or less.

As shown in FIGS. 3 and 4, the diameter of the inscribed circle IC in the first region 201 is preferably larger than 400 nm. It is preferable that a distance d between at least a part of the first regions 201 adjacent to each other in the first direction or the second direction is smaller than 200 nm. The inscribed circle IC is a circle having the maximum area that is in contact with one or more sides of the first region 201 and can exist inside the first region 201.

When the diameter of the inscribed circle IC in the first region 201 is larger than 400 nm, light can easily pass through the first region 201. Further, as the distance d between the first regions 201 becomes longer, the light passing through the first region 201 is isolated, so that the reinforcing effect between the light passing through the adjacent first regions 201 is suppressed. Therefore, the resist has a shape that reacts with each light, and the surface of the lens has a bumpy uneven shape. When the distance d between the first regions 201 is smaller than 200 nm, the surface of the manufactured lens becomes smooth.

In FIGS. 1, 2 and 3, the distance a is kept constant at any place of the photomask 200a, but there are multiple regions having different third light-shielding rates. For example, in FIG. 2, the third light-shielding rate is constant in an arcuate region having a certain radius including the center C, and in the region from the arcuate region having a larger radius to the outside of the arcuate region including the center C described above, the third light-shielding rate is lower than the region in the arcuate region having a certain radius including the center C. Further, the distance a is constant in the multiple regions described above.

Of the multiple first regions 201, the area of the first region 201 near the center C of the photomask 200a is the smallest. The area of each first region 201 increases in proportion to the distance from the center C of the photomask 200a. On the other hand, among the multiple second regions 202, the area of the second region 202 near the center C of the photomask 200a is the largest. The area of each second region 202 becomes smaller in inverse proportion to the distance from the center C of the photomask 200a. Therefore, in the photomask 200a according to the first embodiment, the third light-shielding rates of the unit regions 203 have a gradient along the first direction or the second direction from the center C of the photomask 200a.

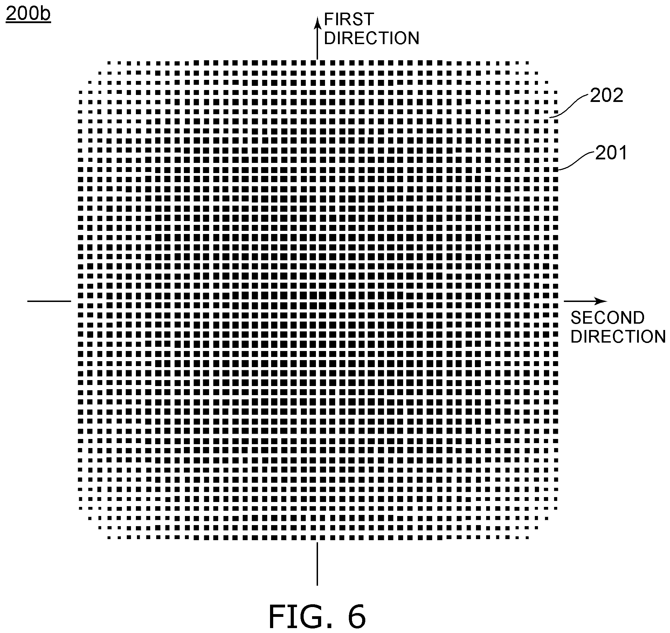

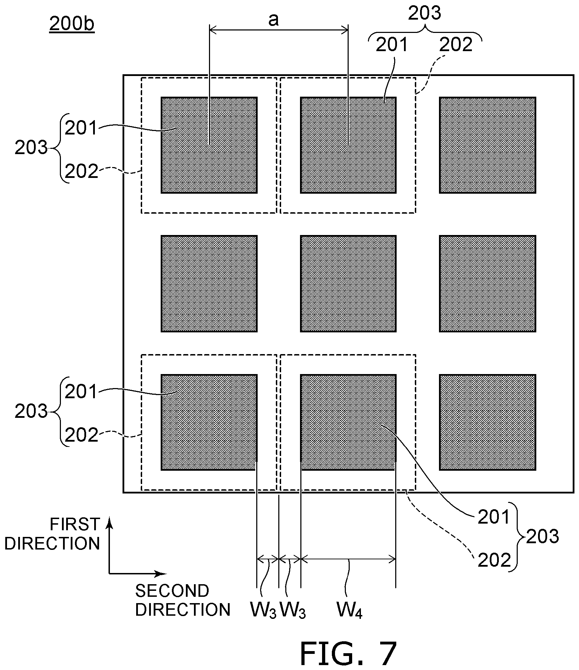

FIG. 6 is a schematic plan view of another photomask not falling under claim 1. FIG. 7 is a schematic plan view of a section of FIG. 6 which is further enlarged. In the photomasks 200b shown in FIGS. 6 and 7, unlike FIGS. 1 to 4, the first light-shielding rate of the first region 201 is higher than the second light-shielding rate of the second region 202. Therefore, in the photomasks 200b of FIGS. 6 and 7, there are a non-light-shielding portion (light transmitting portion) and multiple light-shielding portions. Non-light-shielding portions are arranged around each light-shielding portion.

In FIGS. 6 and 7, the distance connecting the centers of the adjacent first regions 201 is defined as a. When the shape of the first region 201 is, for example, a substantially quadrangle, the center of the first region 201 is obtained and the distance a is calculated in the same manner as in the explanation of FIG. 3. The photomask 200b in FIG. 6 includes multiple light-shielding portions arranged two-dimensionally at equal intervals repeatedly, and non-light-shielding portions arranged around each light-shielding portion. The non-light-shielding portion and the light-shielding portion are arranged so that the light-shielding rate at the central area of the photomask 200b is higher than the light-shielding rate at the peripheral area. One light-shielding portion corresponds to the first region 201. A part of the non-light-shielding portion corresponds to the second region 202.

In the pattern of the photomask 200b of FIG. 6, the third light-shielding rate is high (the transmittance is low) in the vicinity of the center C of the photomask 200b, similarly to the photomask 200a of FIG. 1. This is because the area of the first region 201 is large in the vicinity of the center C, and the area of each first region 201 becomes smaller as the distance from the center C of the photomask 200b increases. That is, the third light-shielding rates of the unit region 203 have a gradient along the first direction or the second direction from the center C of the photomask 200b.

In FIG. 7, the unit region 203 surrounded by the broken line includes the first region 201 and the second region 202, similarly to the one illustrated in FIG. 3. The length of the unit region 203 along the first direction or the second direction is 2 × W₃ + W₄. The third light-shielding rate in FIG. 7 is represented by W₄² / (2W₃ + W₄)² because it is the ratio of the area of the first region 201 in the unit region 203 to the area of the unit region 203.

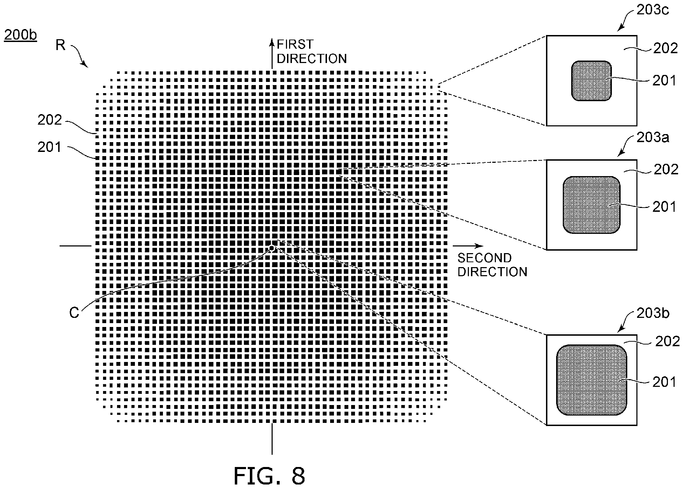

FIG. 8 is a schematic plan view of another photomask not falling under claim 1.

As shown in FIG. 8, in the photomask 200b, the multiple unit regions 203 include the first unit region 203a, the second unit region 203b, and the third unit region 203c. The distance between the center C and the first unit region 203a is longer than the distance between the center C and the second unit region 203b. The distance between the center C and the third unit region 203c is longer than the distance between the center C and the first unit region 203a. The light-shielding rate of the first unit region 203a is lower than the light-shielding rate of the second unit region 203b and higher than the light-shielding rate of the third unit region 203c. For example, the third light-shielding rate of each unit region 203 is not less than 10% and not more than 90%. Each third light-shielding rate is inversely proportional to the square of the distance from the center C. Each third light-shielding rate may be in a relationship obtained by multiplying the ratio inversely proportional to the square of the distance from the center C by the conic constant or the square thereof.

### <Method for manufacturing a photodetector including a lens manufactured using the photomask described>

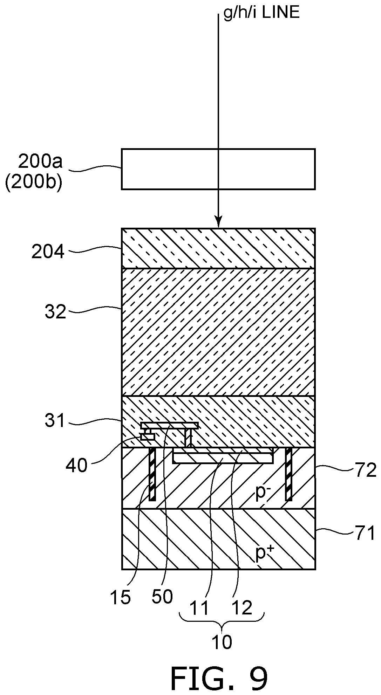

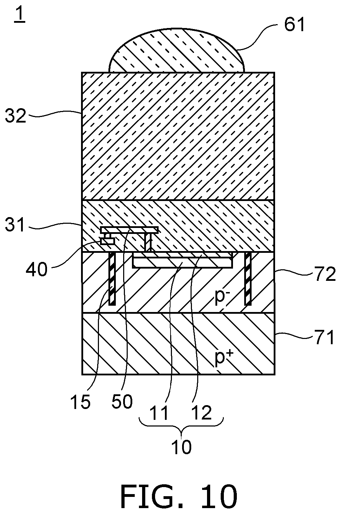

FIG. 9 is a schematic plan view of a method for manufacturing a lens using the photomask according to the first embodiment. FIG. 10 is a schematic plan view of the lens manufactured by the manufacturing method of FIG. 9.

The method for manufacturing the photodetector will be described below. The photodetector includes a lens manufactured using the photomask 200a or 200b described above. First, as shown in FIG. 9, the p⁻-type semiconductor layer 72 is provided on the p⁺-type semiconductor layer 71. The low-concentration silicon p⁻-type semiconductor layer 72 may be epitaxially grown on the surface of the high-concentration p⁺-type semiconductor layer 71. The surface of the high-concentration p⁺-type semiconductor layer 71 is located on the incident side of light. The insulating portion 15 is formed in the p⁻-type semiconductor layer 72. Next, ion implantation is performed to form a p-type semiconductor layer 11 (a first semiconductor region). An n⁺-type semiconductor region 12 (a second semiconductor region) is provided on the p-type semiconductor layer 11. An element 10 of an avalanche photodiode (APD) is formed by the p-type semiconductor layer 11 and the n⁺-type semiconductor region 12. In this way, the insulating portion 15 is provided around the element 10. In addition, polysilicon (a quenching portion 40) for quenching resistance is formed. The quench portion 40 is electrically connected to the n⁺-type semiconductor region 12 via an interconnect 50 and a contact plug. Here, it is possible to form an array in which the elements 10 for detecting light are arranged two-dimensionally. In this case, the element 10 for detecting light and the circuit for selecting the element 10 for detecting light can be provided on the same substrate. After that, the photodetector 1 is manufactured by repeating film formation and patterning of the metal layer to form an interconnect layer (not shown) in the insulating layer 31.

The lens is manufactured, for example, by grating. First, as described above, the element 10 and the insulating layer 31 for detecting light are formed. An insulating layer 32 (for example, a non-photosensitive and flat resist) is formed on the insulating layer 31. Next, 5 µm of a photosensitive positive resist 204 forming the lens 61 is applied thereto. The resist 204 is then baked at 90 °C for 90 seconds. Then, the resist 204 is exposed for 0.8 seconds using the photomask 200a or 200b of the first embodiment. The exposed resist 204 is developed. Then, bleaching is performed, and baking is performed again at 100 °C for 5 minutes and at 200 °C for 5 minutes. As a result, the lens 61 as shown in FIG. 10 can be manufactured. If a minute lens is manufactured by the method described above, a micro lens is formed. By forming multiple micro lenses by the same method, a micro lens array (MLA) in which micro lenses are arranged on a photodetection element array arranged in two dimensions can be obtained. The best conditions such as the exposure time differ depending on the type of the photosensitive resist, the thickness of the resist, and the interval of the mask pattern. Preferably, one lens 61 is provided corresponding to one element 10. The center of the one element 10 in the first surface and the center of the one lens 61 in the first surface are on the same axis. The first surface is parallel to the first direction and the second direction. The same axis crosses the first surface. In other words, when viewed from the third direction crossing the first surface, the center of the element 10 in the first surface overlaps the center of the corresponding lens 61 in the first surface.

As described above, the photomask 200a or 200b according to the first embodiment includes multiple unit regions 203 arranged in the first direction and the second direction. Each unit region 203 includes the first region 201 and the second region 202 provided around the first region 201. The first region 201 has the first light-shielding rate. The second region 202 has the second light-shielding rate different from the first light-shielding rate. The multiple unit regions 203 include the first unit region 203a and the second unit region 203b having the same size as each other. The distance between the first unit region 203a and the center C is different from the distance between the second unit region 203b and the center C. The third light-shielding rate of the first unit region 203a is different from the third light-shielding rate of the second unit region 203b.

### [Example]

### (Example 1)

In order to realize the first embodiment, first, the three-dimensional shape of the lens is calculated by using an optical simulation or the like. The height of the lens at each coordinate in the three-dimensional shape was converted into an aperture ratio corresponding to the height by spreadsheet software. Further, in order to obtain the aperture ratio, the size of the first region 201 converted into a ratio of the square of the distance a and the area of the first region 201 was calculated, and a numerical table of the coordinates and the size of the first region 201 was created. The created numerical table is read by a computer, and a light-shielding pattern with an opening hole for each coordinate is converted into mask data. The photomask of FIG. 1 was manufactured by forming a metal layer corresponding to the light-shielding pattern on the surface of a light-transmitting glass substrate. The metal layer includes, for example, chromium.

The distance a in the manufactured photomask is 1250 nm, and there is a gradient of the third light-shielding rates in the direction away from the center of the photomask. Using this photomask, a lens group was manufactured by the above-mentioned lens manufacturing method.

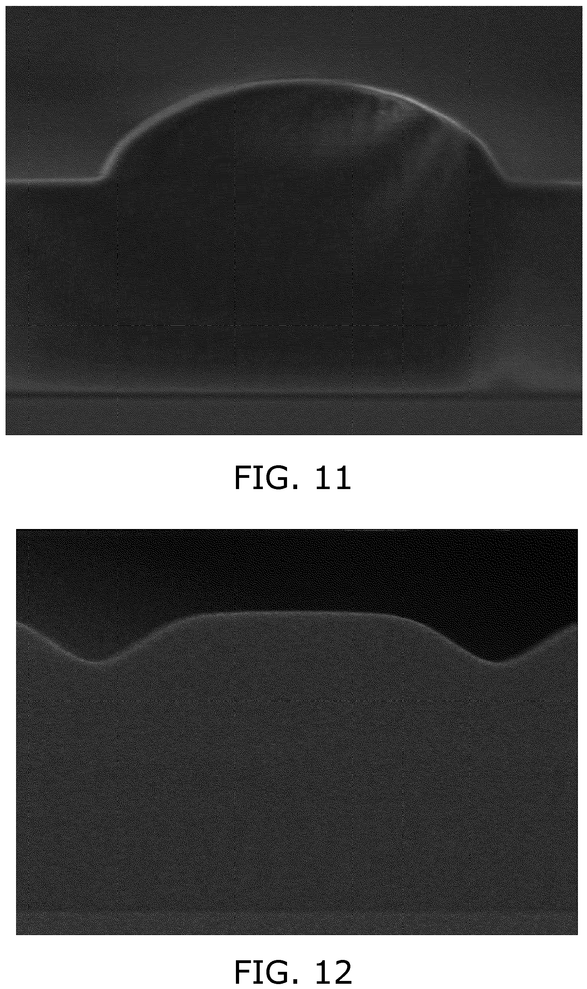

FIGS. 11 and 12 are images of an electron microscope in a cross section of the lens manufactured by using a photomask according to the example 1.

The manufactured lens surface is sufficiently smooth. Therefore, the incident light is less scattered on the lens surface, and the light is refracted and incident. Using ZEMAX as analysis software, the transmittance was calculated by a ray tracing method when linear light was incident from directly above the lens. The transmittance is 93%, and a photodetection element equipped with this lens is expected to have high photon detection efficiency.

In the photomask 200a or 200b, the shape of the manufactured lens can be arbitrarily adjusted by adjusting the gradient of the third light-shielding rates of the multiple unit regions 203. For example, in the photomask 200a or 200b, the third light-shielding rate of each unit region 203 near the center C is the same as each other. By increasing the number of unit regions 203 having the same third light-shielding rate, as shown in FIG. 12, a lens having a flat surface near the center can be manufactured.

### (Example 2)

In example 2, the photomask 200b shown in FIG. 6 was manufactured. The photomask 200b has multiple island-shaped second regions 202. The distance a between the centers of the second regions 202 adjacent to each other in the first direction or the second direction is 1250 nm. The elements other than these in the example 2 are the same as those in the example 1. Using this photomask 200b, a lens group was manufactured by the above-mentioned lens manufacturing method.

The surface of the manufactured lens was sufficiently smooth. Therefore, the incident light is less scattered on the lens surface, and the light is refracted and incident. As a result of analyzing the transmittance in the same manner as in example 1, the transmittance was 93%. A photodetector equipped with this lens is expected to have high photon detection efficiency.

### (Comparative example 1)

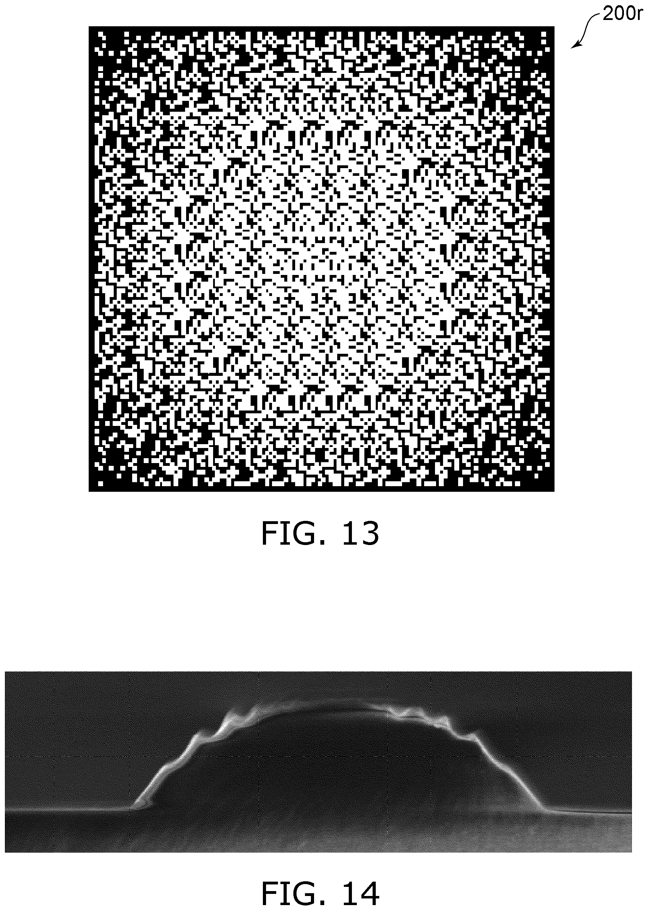

FIG. 13 is a plan view of a photomask according to a comparative example 1. In the comparative example 1, a photomask 200r shown in FIG. 13 was manufactured. In the photomask 200r, each of the multiple regions arranged in two dimensions is either a non-light-shielding region or a light-shielding region. By changing the density of the non-light-shielding region and the density of the light-shielding region from the center of the photomask 200r to the outside, a gradient of the light-shielding rates is formed. Using this photomask 200r, a lens set was manufactured by the above-mentioned lens manufacturing method.

FIG. 14 is an image of an electron microscope in a cross section of a lens manufactured by using a photomask according to the comparative example 1. The surface of the manufactured lens is not smooth and the surface roughness is large. Therefore, the incident light is scattered on the surface, which leads to a decrease in transmittance. Therefore, a photodetection element equipped with this lens is not expected to have high photon detection efficiency.

### (Example 3)

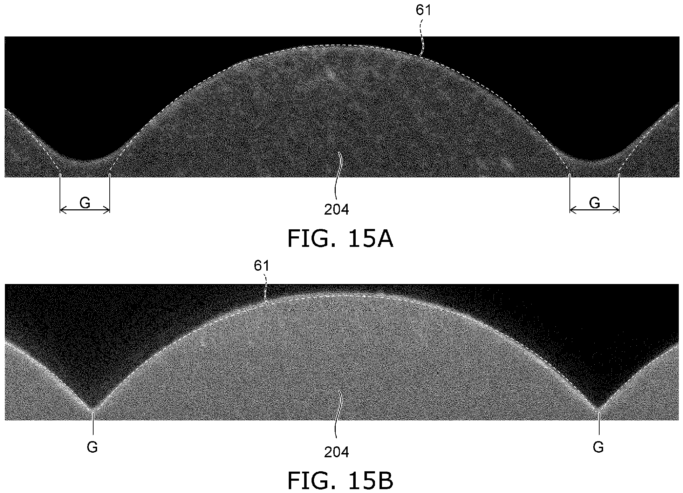

FIG. 15A is an image of an electron microscope of a cut cross section of a lens manufactured by using a photomask according to an example 3, FIG. 15B is an image of the electron microscope of the cut cross section of the lens after processing the lens shown in FIG. 15A.

In the example shown in FIG. 15A, multiple convex lenses 61 are formed on the surface of the resist 204. In FIG. 15A, a broken line is attached to a portion that functions as the lens 61. As shown in FIG. 15A, there is a gap G between the lenses 61. The light incident in the gap G is not refracted toward the element 10. In order to improve the photon detection efficiency of the photodetector 1, it is preferable that the gap G is small.

In the example 3, the resist 204 shown in FIG. 15A is etched back by reactive ion etching (RIE). By etching back, a part of the resist 204 is removed while maintaining the shape of the lenses 61. At this time, by increasing the straightness of the ions incident on the resist 204, the gap G can be made smaller as shown in FIG. 15B. For example, the gap G can be made substantially zero, and the lenses 61 can be brought into contact with each other. This makes it possible to further improve the photon detection efficiency of the photodetector 1.

### (Example 4)

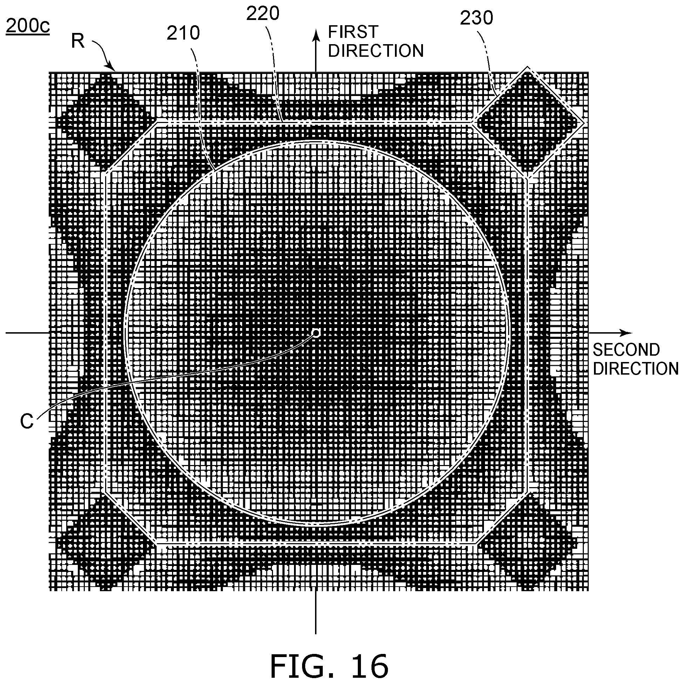

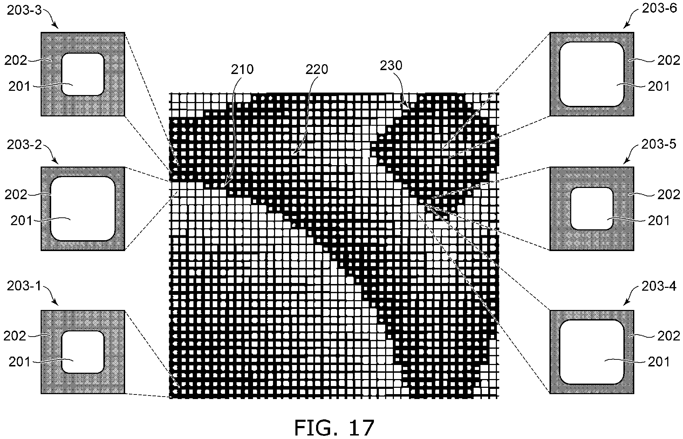

FIG. 16 is a schematic plan view of another photomask according to the first embodiment. FIG. 17 is a schematic plan view of an enlarged part of FIG. 16.

In FIGS. 16 and 17, the white portion is the first region 201. The black portion is the second region 202. For example, the first region 201 is more likely to transmit light than the second region 202. The first region 201 is a non-light-shielding portion. The second region 202 is a light-shielding portion. That is, the relationship between the light-shielding rate of the first region 201 and the light-shielding rate of the second region 202 in a photomask 200c shown in FIG. 16 is the same as the relationship between the light-shielding rate of the light-shielding rate of the first region 201 and the light-shielding rate of the second region 202 in the photomask 200a shown in FIG. 1.

As shown in FIG. 16, in the photomask 200c, the third light-shielding rates of the multiple unit regions 203 have multiple gradients from the center C toward the outer circumference. Specifically, the range R in which the multiple unit regions 203 are arranged includes a first portion 210 and a second portion 220. The first portion 210 includes the center C of the range R and its vicinity. The second portion 220 is provided around the first portion 210.

As shown in FIG. 17, multiple unit regions 203 are arranged two-dimensionally in each of the first portion 210 and the second portion 220. In the first portion 210, the third light-shielding rates of the multiple unit regions 203 have a gradient from the center toward the outer circumference of the first portion 210. The gradient of the third light-shielding rates from the outer circumference of the first portion 210 toward the inner circumference of the second portion 220 is opposite toward the gradient of the third light-shielding rates from the center toward the outer circumference of the first portion 210. The gradient in the third light-shielding rates from the outer circumference of the first portion 210 toward the inner circumference of the second portion 220 is steeper than the gradient of the third light-shielding rates from the center toward the outer circumference of the first portion 210.

In the second portion 220, the third light-shielding rates of the multiple unit regions 203 have a gradient toward the outer circumference of the second portion 220. The gradient of the third light-shielding rates from the inner circumference toward the outer circumference of the second portion 220 is opposite toward the gradient of the third light-shielding rates from the outer circumference of the first portion 210 toward the inner circumference of the second portion 220. The change in the third light-shielding rate from the inner circumference toward the outer circumference of the second portion 220 is more gradual than the change in the third light-shielding rate from the outer circumference of the first portion 210 toward the inner circumference of the second portion 220.

In the photomask 200c shown in FIG. 16, the third light-shielding rate of the unit region 203 decreases from the center toward the outer circumference of the first portion 210. The third light-shielding rate of the unit region 203 increases from the outer circumference of the first portion 210 toward the inner circumference of the second portion 220. The third light-shielding rate of the unit region 203 decreases from the inner circumference toward the outer circumference of the second portion 220.

As shown in FIG. 17, the size of the first region 201 of the unit region 203-1 provided in the central area of the first portion 210 is smaller than the size of the first region 201 of the unit region 203-2 provided on the outer circumference of the first portion 210. The size of the first region 201 of the unit region 203-2 is larger than the size of the first region 201 of the unit region 203-3 provided on the inner circumference of the second portion 220. The size of the first region 201 of a unit region 203-4 provided on the outer circumference of the second portion 220 is larger than the size of the first region 201 of the unit region 203-3.

As shown in FIG. 16, the photomask 200c may further include a third portion 230. Multiple third portions 230 are provided around the second portion 220. In the illustrated example, four third portions 230 are provided. The four third portions 230 are located at the corners of an imaginary square surrounding the first portion 210 and the second portion 220.

The multiple unit regions 203 are also arranged two-dimensionally in the third portion 230. In the third portion 230, the third light-shielding rates of the multiple unit regions 203 have a gradient from the outer circumference to the center of the third portion 230. For example, the light-shielding rate of the unit region 203 increases from the outer circumference of the second portion 220 toward the outer circumference of the third portion 230. The light-shielding rate of the unit region 203 decreases from the outer circumference toward the center of the third portion 230.

As shown in FIG. 17, the size of the first region 201 of a unit region 203-5 provided on the outer circumference of the third portion 230 is smaller than the size of the first region 201 of the unit region 203-4. The size of the first region 201 of the unit region 203-6 provided at the center of the third portion 230 is larger than the size of the first region 201 of the unit region 203-5.

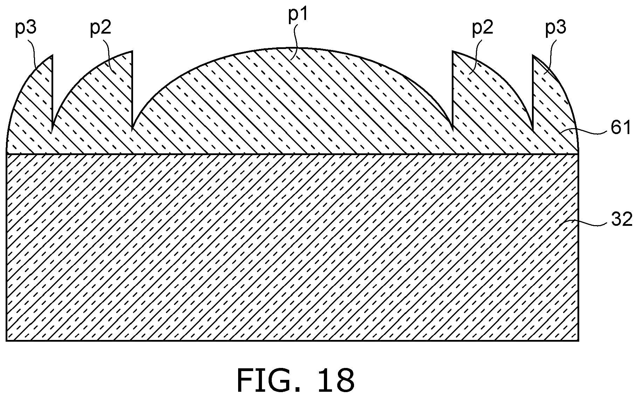

FIG. 18 is an image of an electron microscope in a cross section of a lens manufactured by using the photomask according to the example 4.

In the example 4, the lens 61 was manufactured using the photomask 200c shown in FIG. 16. As shown in FIG. 18, multiple convex portions are also formed on the surface of the manufactured lens 61 according to the multiple gradients of the light-shielding rates in the photomask 200c. In the illustrated example, the lens 61 includes convex portions p1 to p3. The convex portion p1 is formed corresponding to the first portion 210. The convex portion p2 is formed corresponding to the second portion 220. The convex portion p3 is formed corresponding to the third portion 230.

### [Second embodiment]

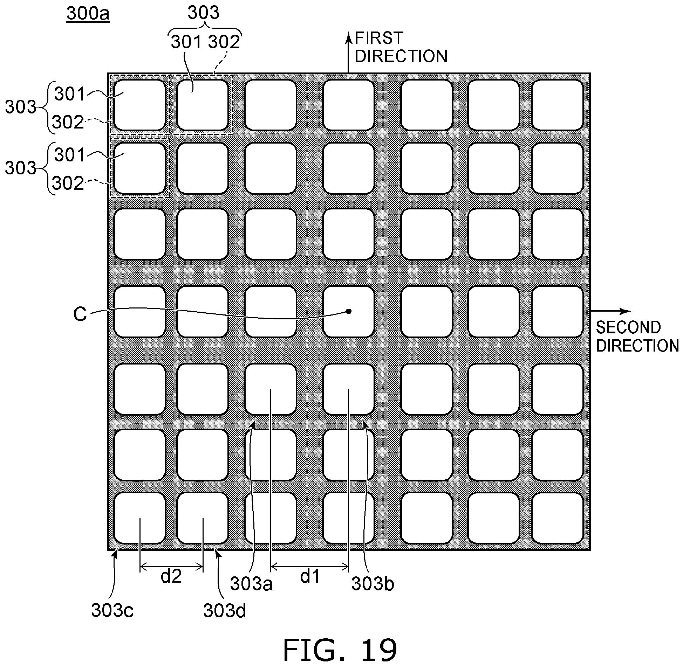

FIG. 19 is a schematic plan view of a photomask according to a second embodiment, not falling under claim 1.

A photomask 300a shown in FIG. 19 includes multiple unit regions arranged in a two-dimensional manner. Each unit region 303 includes a first region 301 and a second region 302. The second region 302 is provided around the first region 301. The light-shielding rate of the first region 301 is different from the light-shielding rate of the second region 302. In the illustrated example, the light-shielding rate of the first region 301 is smaller than the light-shielding rate of the second region 302.

The sizes of the first regions 301 are the same as each other. The distance between the first regions 301 adjacent to each other in the first direction or the second direction changes along the first direction or the second direction. In the photomask 300a, the distance between the first regions 301 becomes smaller as the distance from the center C of the photomask 300a increases. That is, in the photomask 300a, the distance between the adjacent first regions 301 changes from the center C toward the outer circumference, so that the third light-shielding rates of the multiple unit regions 303 have a gradient.

For example, the multiple unit regions 303 include unit regions 303a to 303d. Each of the distance between the unit region 303a and the center C and the distance between the unit region 303b and the center C is shorter than each of the distance between the unit region 303c and the center C and the distance between the unit region 303d and the center C. The distance d1 between the first region 301 of the unit region 303a and the first region 301 of the unit region 303b is longer than the distance d2 between the first region 301 of the unit region 303c and the first region 301 of the unit region 303d.

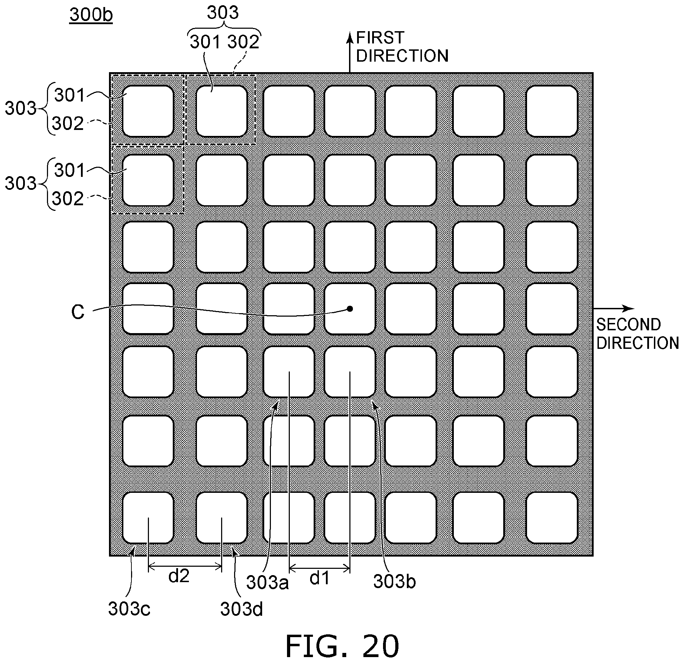

FIG. 20 is a schematic plan view of another photomask according to the second embodiment, not falling under claim 1.

In a photomask 300b shown in FIG. 20, the distance between the first regions 301 increases as the distance from the center C of the photomask 300 increases. For example, the distance d1 between the first region 301 of the unit region 303a and the first region 301 of the unit region 303b is shorter than the distance d2 between the first region 301 of the unit region 303c and the first region 301 of the unit region 303d.

As in the second embodiment, the gradient of the light-shielding rates may be controlled by adjusting the distance between the first regions 201 having the same size. Even when the photomask according to the second embodiment is used, a lens having a smooth surface shape can be manufactured as in the case where the photomask according to the first embodiment is used.

In the photomask specifically described above, the third light-shielding rate of the unit region 203 near the center C is higher than the third light-shielding rate of the unit region 203 far from the center C. These photomasks are used when exposing to positive photoresists. In the photomasks 200a, 200b, 300a, or 300b, the relationship between the first light-shielding rate and the second light-shielding rate in each unit region may be reversed while maintaining the size of each first region and the size of each second region. In that case, a photomask used when exposing to a negative photoresist is obtained.

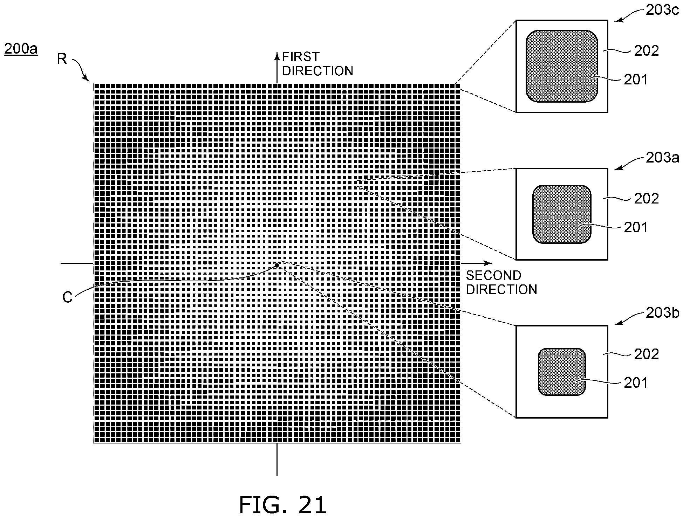

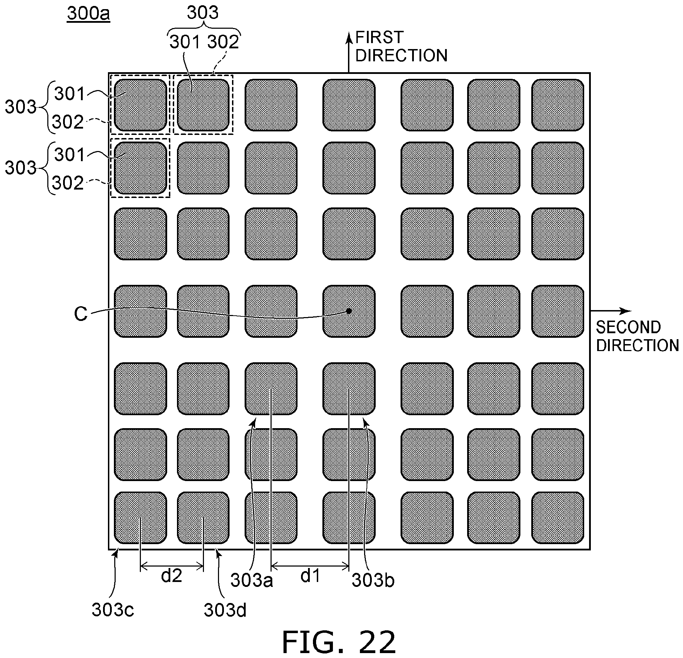

FIGS. 21 and 22 are schematic plan views of another photomask according to the embodiment, not falling under claim 1.

FIG. 21 shows the photomask 200a that can be used for a negative photoresist. The first light-shielding rate of the first region 201 is higher than the second light-shielding rate of the second region 202. The multiple unit regions 203 include the first unit region 203a, the second unit region 203b, and the third unit region 203c. The distance between the center C and the first unit region 203a is longer than the distance between the center C and the second unit region 203b. The distance between the center C and the third unit region 203c is longer than the distance between the center C and the first unit region 203a. The light-shielding rate of the first unit region 203a is higher than the light-shielding rate of the second unit region 203b and is lower than the light-shielding rate of the third unit region 203c. For example, the light-shielding rate of the second unit region 203b provided near the center C of the photomask 200a is 10%, and the light-shielding rate of the third unit region 203c farthest from the center C of the photomask 200a is 90%.

FIG. 22 shows the photomask 300a that can be used for a negative photoresist. The first light-shielding rate of the first region 301 is higher than the second light-shielding rate of the second region 302. The multiple unit regions 303 include unit regions 303a to 303d. Each of the distance between the unit region 303a and the center C and the distance between the unit region 303b and the center C is shorter than each of the distance between the unit region 303c and the center C and the distance between the unit region 303d and the center C. The distance d1 between the first region 301 of the unit region 303a and the first region 301 of the unit region 303b is longer than the distance d2 between the first region 301 of the unit region 303c and the first region 301 of the unit region 303d.

Even when a negative type photoresist photomask as shown in FIG. 21 or FIG. 22 is used, a lens having a smooth surface can be manufactured as in the case of using the positive type photoresist photomask described above.

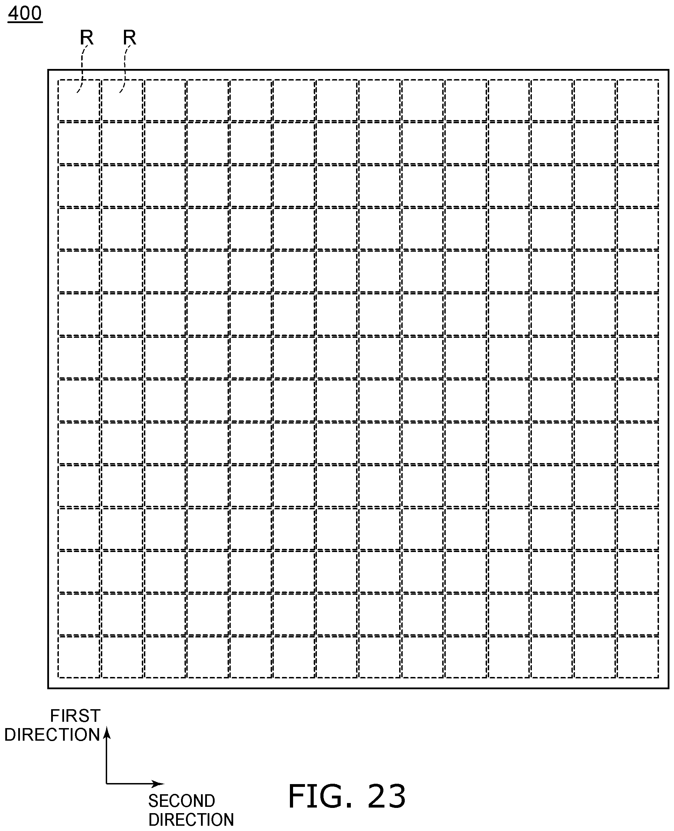

FIG. 23 is a schematic plan view of another photomask according to the embodiment, not falling under claim 1.

As in a photomask 400 shown in FIG. 23, multiple ranges R may be arranged two-dimensionally. In each range R, multiple unit regions 203 are arranged. Each range R has a light-shielding rate gradient for forming one lens, and corresponds to the photomask 200a shown in FIG. 1, the photomask 200b shown in FIG. 6, the photomask 300a shown in FIG. 19, or the photomask 300b shown in FIG. 20. MLA can be formed by exposing the resist 204 with the photomask 400.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in photodetectors such as elements, semiconductor regions, insulating portions, insulating layers, interconnects, contact plugs, lenses, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all photodetectors, photodetection systems, lidar devices, and mobile bodies practicable by an appropriate design modification by one skilled in the art based on the photodetectors, the photodetection systems, the lidar devices, and the mobile bodies described above as embodiments of the invention also are within the scope of the invention to the extent that the purport of the invention is included, the invention being defined by the scope of the appended claims only.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made, while remaining within the scope of the invention as defined by the appended claims.

## Claims

1. A photomask (200a, 200c), comprising:
a plurality of unit regions (203) arranged in a first direction and a second direction crossing the first direction,
each of the unit regions including
a first region (201) having a first light-shielding rate, and
a second region (202) having a second light-shielding rate higher than the first light-shielding rate, and provided around the first region,
**characterized in that** the unit regions includes a first unit region (203a) and a second unit region (203b) having same size each other,
a distance between the first unit region and a center (C) of a range (R) in which the unit regions are arranged being longer than a distance between the second unit region and the center, and
a light-shielding rate of the first unit region is lower than a light-shielding rate of the second unit region,
wherein the second regions (202) adjacent to each other in the first direction or the second direction are in contact with each other.

2. The photomask (200a, 200c) according to claim 1, wherein
a size of the first region (201) included in the first unit region (203a) is different from a size of the first region included in the second unit region (203b).

3. The photomask (200a, 200c) according to claim 1 or claim 2, wherein
the unit regions (203) further include a third unit region (203c) having same size as the first unit region (203a) or the second unit region (203b),
the distance between the first unit region and the center (C) is shorter than a distance between the third unit region and the center, and
the light-shielding rate of the first unit region is higher than a light-shielding rate of the third unit region, and lower than the light-shielding rate of the second unit region.

4. The photomask (200a, 200c) according to any one of claims 1 to 3, wherein
each of a plurality of the first regions (201) has a size corresponding to a distance from the center (C).

5. The photomask (200a) according to any one of claims 1 to 4, wherein
a light-shielding rate of each of the unit regions (203) is inversely proportional to a square of a distance from the center.

6. The photomask (200a, 200c) according to any one of claims 1 to 4, wherein
a light-shielding rate of each of the unit regions (203) is in a relationship obtained by multiplying a ratio inversely proportional to a square of a distance from the center (C) by a conic constant in a range of -0.2 to -5.0 or a square of the conic constant.

7. The photomask (200a, 200c) according to claim 3, wherein
a light-shielding rate of each of the unit regions is not less than 10% and not more than 90%.

8. The photomask (200a) according to any one of claims 1 to 7, wherein
an area of each of a plurality of the first regions (201) increases in proportion to a distance from the center.

9. The photomask (200a, 200c) according to any one of claims 1 to 8, wherein
the unit regions (203) are arranged in the first direction and the second direction at an interval of a first distance (a).

10. The photomask (200a, 200c) according to claim 9, wherein
the first distance (a) is not less than 500 nm and not more than 2500 nm.

11. The photomask (200a, 200c) according to any one of claims 1 to 10, wherein
a diameter of at least one of inscribed circles (IC) in a plurality of the first regions (201) is larger than 400 nm,
the first regions include adjacent first regions in the first direction or the second direction, and
a distance between the adjacent first regions is shorter than 200 nm.

12. A method for manufacturing a lens (61), comprising:
exposing a resist (204) on a photodetection element (10) by using the photomask (200a, 200c) according to any one of claims 1 to 11; and
developing the resist.

13. A method for manufacturing a photodetector (1), comprising:
forming a photodetection element (10);
exposing a resist (204) on a photodetection element by using the photomask according (200a, 200c) to any one of claims 1 to 11; and
forming a lens (61) by developing the resist.

## Patentansprüche

1. Fotomaske (200a, 200c), die Folgendes umfasst: eine Vielzahl von Einheitsbereichen (203), die in einer ersten Richtung und einer zweiten Richtung, die die erste Richtung kreuzt, angeordnet sind, wobei jeder der Einheitsbereiche einen ersten Bereich (201) mit einer ersten Lichtabschirmrate und einen zweiten Bereich (202) mit einer zweiten Lichtabschirmrate, die höher als die erste Lichtabschirmrate ist, und um den ersten Bereich herum vorgesehen ist, umfasst, **dadurch gekennzeichnet, dass** die Einheitsbereiche einen ersten Einheitsbereich (203a) und einen zweiten Einheitsbereich (203b) mit gleicher Größe umfassen, wobei ein Abstand zwischen dem ersten Einheitsbereich und einem Zentrum (C) eines Bereichs (R), in dem die Einheitsbereiche angeordnet sind, größer ist als ein Abstand zwischen dem zweiten Einheitsbereich und dem Zentrum, und eine Lichtabschirmrate des ersten Einheitsbereichs niedriger ist als eine Lichtabschirmrate der zweiten Einheitsbereichs, wobei die zweiten Bereichen (202), die in der ersten Richtung oder der zweiten Richtung aneinander angrenzen, miteinander in Kontakt sind.

2. Fotomaske (200a, 200c) gemäß Anspruch 1, wobei eine Größe des ersten Bereichs (201), der in dem ersten Einheitsbereich (203a) umfasst ist, sich von einer Größe des ersten Bereichs unterscheidet, der in dem zweiten Einheitsbereich (203b) umfasst ist.

3. Fotomaske (200a, 200c) gemäß Anspruch 1 oder 2, wobei die Einheitsbereiche (203) ferner einen dritten Einheitsbereich (203c) mit derselben Größe wie der erste Einheitsbereich (203a) oder der zweite Einheitsbereich (203b) umfassen,
der Abstand zwischen dem ersten Einheitsbereich und dem Zentrum (C) kleiner ist als ein Abstand zwischen dem dritten Einheitsbereich und dem Zentrum, und
die Lichtabschirmrate des ersten Einheitsbereichs höher ist als eine Lichtabschirmrate des dritten Einheitsbereichs und niedriger als die Lichtabschirmrate des zweiten Einheitsbereichs.

4. Fotomaske (200a, 200c) gemäß einem der Ansprüche 1 bis 3, wobei jeder einer Vielzahl der ersten Bereiche (201) eine Größe aufweist, die einem Abstand von dem Zentrum (C) entspricht.

5. Fotomaske (200a) gemäß einem der Ansprüche 1 bis 4, wobei eine Lichtabschirmrate jeder der Einheitsbereiche (203) umgekehrt proportional zum Quadrat eines Abstands von dem Zentrum ist.

6. Fotomaske (200a, 200c) gemäß einem der Ansprüche 1 bis 4, wobei eine Lichtabschirmrate jeder der Einheitsbereiche (203) in einer Beziehung steht, die durch Multiplizieren eines Verhältnisses, das umgekehrt proportional zu einem Quadrat eines Abstandes von dem Zentrum (C) ist, mit einer konischen Konstanten in einem Bereich von -0,2 bis **-**5,0 oder einem Quadrat der konischen Konstanten erhalten wird.

7. Fotomaske (200a, 200c) gemäß Anspruch 3, wobei eine Lichtabschirmrate jeder der Einheitsbereiche nicht weniger als 10 % und nicht mehr als 90 % beträgt.

8. Fotomaske (200a) gemäß einem der Ansprüche 1 bis 7, wobei eine Fläche jedes einer Vielzahl der ersten Bereiche (201) proportional zu einem Abstand von dem Zentrum zunimmt.

9. Fotomaske (200a, 200c) gemäß einem der Ansprüche 1 bis 8, wobei die Einheitsbereiche (203) in der ersten Richtung und der zweiten Richtung in einem Intervall einer ersten Distanz (a) angeordnet sind.

10. Fotomaske (200a, 200c) gemäß Anspruch 9, wobei die erste Distanz (a) nicht weniger als 500 nm und nicht mehr als 2500 nm beträgt.

11. Fotomaske (200a, 200c) gemäß einem der Ansprüche 1 bis 10, wobei ein Durchmesser von mindestens einem von einbeschriebenen Kreisen (IC) in einer Vielzahl der ersten Bereiche (201) größer als 400 nm ist, die ersten Bereiche benachbarte erste Bereiche in der ersten Richtung oder der zweiten Richtung umfassen und ein Abstand zwischen den benachbarten ersten Bereichen kürzer als 200 nm ist.

12. Verfahren zur Herstellung einer Linse (61), Folgendes umfassend: Belichten eines Lacks (204) auf einem Fotodetektorelement (10) unter Verwendung der Fotomaske (200a, 200c) gemäß einem der Ansprüche 1 bis 11; und Entwickeln des Lacks.

13. Verfahren zur Herstellung eines Fotodetektors (1), Folgendes umfassend: Ausbilden eines Fotodetektionselements (10); Belichten eines Lacks (204) auf einem Fotodetektionselement unter Verwendung der Fotomaske (200a, 200c) gemäß einem der Ansprüche 1 bis 11; und
Ausbilden einer Linse (61) durch Entwickeln des Lacks.

## Revendications

1. Photomasque (200a, 200c), comprenant :
une pluralité de régions unitaires (203) agencées dans une première direction et une deuxième direction croisant la première direction, chacune des régions unitaires incluant
une première région (201) ayant un premier taux d'opacité, et
une deuxième région (202) ayant un deuxième taux d'opacité supérieur au premier taux d'opacité, et prévue autour de la première région,
**caractérisé en ce que** les régions unitaires incluent une première région unitaire (203a) et une deuxième région unitaire (203b) ayant la même taille l'une et l'autre,
une distance entre la première région unitaire et un centre (C) d'une plage (R) dans laquelle les régions unitaires sont agencées étant plus longue qu'une distance entre la deuxième région unitaire et le centre, et
un taux d'opacité de la première région unitaire est inférieur à un taux d'opacité de la deuxième région unitaire,
dans lequel les deuxièmes régions (202) adjacentes les unes aux autres dans la première direction ou la deuxième direction sont en contact les unes avec les autres.

2. Photomasque (200a, 200c) selon la revendication 1, dans lequel une taille de la première région (201) incluse dans la première région unitaire (203a) est différente d'une taille de la première région incluse dans la deuxième région unitaire (203b).

3. Photomasque (200a, 200c) selon la revendication 1 ou la revendication 2, dans lequel
les régions unitaires (203) incluent en outre une troisième région unitaire (203c) ayant la même taille que la première région unitaire (203a) ou la deuxième région unitaire (203b),
la distance entre la première région unitaire et le centre (C) est plus courte qu'une distance entre la troisième région unitaire et le centre, et
le taux d'opacité de la première région unitaire est supérieur à un taux d'opacité de la troisième région unitaire, et inférieur au taux d'opacité de la deuxième région unitaire.

4. Photomasque (200a, 200c) selon l'une quelconque des revendications 1 à 3, dans lequel
chacune d'une pluralité des premières régions (201) a une taille correspondant à une distance par rapport au centre (C).

5. Photomasque (200a) selon l'une quelconque des revendications 1 à 4, dans lequel
un taux d'opacité de chacune des régions unitaires (203) est inversement proportionnel à un carré d'une distance par rapport au centre.

6. Photomasque (200a, 200c) selon l'une quelconque des revendications 1 à 4, dans lequel
un taux d'opacité de chacune des régions unitaires (203) est dans une relation obtenue en multipliant un rapport inversement proportionnel à un carré d'une distance par rapport au centre (C) par une constante conique dans une plage de -0,2 à -5,0 ou un carré de la constante conique.

7. Photomasque (200a, 200c) selon la revendication 3, dans lequel
un taux d'opacité de chacune des régions unitaires n'est pas inférieur à 10 % et n'est pas supérieur à 90 %.

8. Photomasque (200a) selon l'une quelconque des revendications 1 à 7, dans lequel
une superficie de chacune d'une pluralité des premières régions (201) augmente proportionnellement à une distance par rapport au centre.

9. Photomasque (200a, 200c) selon l'une quelconque des revendications 1 à 8, dans lequel
les régions unitaires (203) sont agencées dans la première direction et la deuxième direction à un intervalle d'une première distance (a).

10. Photomasque (200a, 200c) selon la revendication 9, dans lequel la première distance (a) n'est pas inférieure à 500 nm et n'est pas supérieure à 2500 nm.

11. Photomasque (200a, 200c) selon l'une quelconque des revendications 1 à 10, dans lequel
un diamètre d'au moins un des cercles inscrits (IC) dans une pluralité des premières régions (201) est supérieur à 400 nm,
les premières régions incluent des premières régions adjacentes dans la première direction ou la deuxième direction, et
une distance entre les premières régions adjacentes est inférieure à 200 nm.

12. Procédé de fabrication d'une lentille (61), comprenant :
une exposition d'une résine (204) sur un élément (10) de photodétection à l'aide du photomasque (200a, 200c) selon l'une quelconque des revendications 1 à 11 ; et
un développement de la réserve.

13. Procédé de fabrication d'un photodétecteur (1), comprenant :
une formation d'un élément (10) de photodétection ;
une exposition d'une résine (204) sur un élément de photodétection à l'aide du photomasque (200a, 200c) selon l'une quelconque des revendications 1 à 11 ; et
une formation d'une lentille (61) par développement de la résine.
